Europäisches Patentamt

European Patent Office

Office européen des brevets

(11) Publication number: **0 608 617 A2**

# EUROPEAN PATENT APPLICATION

(21) Application number: **93309853.5**

(22) Date of filing: **08.12.93**

(51) Int. Cl.⁵: **H03K 3/53**

(30) Priority: **28.12.92 US 997983**

(43) Date of publication of application:
**03.08.94 Bulletin 94/31**

(84) Designated Contracting States:
**DE FR GB**

(71) Applicant: **AT&T Corp.**
**32 Avenue of the Americas**
**New York, NY 10013-2412(US)**

(72) Inventor: **Bergmann, Ernest Eisenhardt**
**730 Seneca Street**
**Bethlehem, Pennsylvania 18015(US)**

(74) Representative: **Buckley, Christopher Simon**
**Thirsk et al**
**AT&T (UK) LTD.,**
**AT&T Intellectual Property Division,**
**5 Mornington Road**
**Woodford Green, Essex IG8 0TU (GB)**

(54) **Current multiplication network.**

(57) A current multiplication network includes a plurality of charge storage devices (e.g., transmission lines (TLs) or capacitors), connected to a power supply. During each time interval in which current is to be delivered to a load, the network is configured into two or more subsets of devices. A first subset (e.g., TL1) of devices is connected to the supply (12) and is charged. Essentially simultaneously, a second subset (e.g., TL2) of devices, is connected to the load (14) and is discharged into the load. The total charge 2Q delivered to the load in a given time interval is the sum of the charge Q delivered by the supply plus the charge Q delivered by the discharging subset, thereby providing the desired current multiplication. Other network configurations are also described.

*FIG. 3*

## Background of the Invention

This invention relates to current multiplication networks and, more particularly, to circuits for delivering more average current to a load than is supplied by the power supply.

In most electronics applications, the voltage of the power supply is specified either by the circuit design or the system specifications, leaving the designer with essentially one degree of freedom (the average current or power) to control power dissipation. For example, in a lightwave digital system, an LED driver is often powered from a 5V supply designed to draw, say, a continuous current of 50 mA, corresponding to an average power of 250 mW. In this design, the supply current is switched between the LED and a resistive shunt path in response to the digital signal. Alternatively, the shunt path could be omitted, and 50 mA of peak current could be delivered to the LED typically at a lower duty cycle (assuming a mixed pattern of ones and zeros in the digital signal).

However, there is often a need to supply higher average current to the load than is being drawn from the power supply.

## Summary of the Invention

This need is addressed in accordance with one aspect of the invention, a current multiplication network comprising a plurality of charge storage devices (CSDs) coupled between a power supply and a load so as to deliver to the load a higher average current than is drawn from the supply. The class of suitable CSDs includes, for example, open-circuited transmission lines, microstorage batteries, and simple capacitors. Which type of CSD is chosen will depend upon system considerations, such as the baud rate of a digital signal.

Thus, in one embodiment of the invention, the network includes a plurality N of CSDs connected to a power supply which delivers a charge Q. During each time interval $2\tau$, such as the reciprocal of the baud rate of a digital signal, the network is configured into two or more subsets of CSDs. In a first subset of J CSDs (J < N), each CSD is connected to the supply and is charged to a first level (typically Q). Essentially simultaneously, in a second subset of K CSDs (J + K ≤ N), the CSDs are connected to the load and discharge a second quantity of charge into the load. The second charge is summed in the load with the supply charge, the change in total charge during the time interval $2\tau$ providing the desired current multiplication. It should be noted that the invention allows for the possibility that a third subset of L CSDs remain idle during each time interval. In this case, J + K + L = N, but the principle of current multiplication remains the same.

One of the simplest, and perhaps preferred, versions of this embodiment utilizes two CSDs, with the load being switched alternately between the CSDs so that, during time intervals determined by the baud rate of the digital signal, an average current of 2I is delivered to the load from a power supply which supplies only a current I.

In another aspect of the invention, the network includes a plurality N of CSDs arranged to have a first configuration during a first charging time interval and a second configuration during a second discharging time interval. In a digital system, switching between the two network configurations is responsive to the pattern of the digital signal.

In one embodiment of this aspect of the invention, during the first charging time interval N CSDs are connected in series with a power supply that delivers a charge Q. Thus, each CSD is charged to a level Q. During the second discharging time interval, the N CSDs are connected in parallel with a load and discharge into the load a charge NxQ.

## Brief Description of the Drawings

The invention, together with its various features and advantages, can be readily understood from the following more detailed description taken in conjunction with accompanying drawing, in which:

FIG. 1 is a schematic of an illustrative embodiment of the invention showing how a network of CSDs has one configuration during a charging interval and another configuration during a discharging interval;

FIG. 2 is a schematic of one embodiment of the invention using a switched capacitor network to deliver an average current 2I to load while drawing only a current I from a supply;

FIG. 3 is a schematic of another embodiment of the invention using two transmission lines (TLs) to deliver an average current 2I to a load during predetermined time intervals shown in FIG. 4;

FIG. 4 is a table showing how the TLs in the embodiment of FIG. 3 are either charged or discharged in predetermined time intervals in response to an illustrative digital signal represented by the binary bit stream 110101;

FIG. 5 is a schematic of another embodiment of the invention using three TLs to deliver an average current $3I/2$ to a load during predetermined time intervals shown in FIG. 6; and

FIG. 6 is a table showing how the TLs in the embodiment of FIG. 5 are either charged or discharged in predetermined time intervals in response to an illustrative digital signal represented by the binary bit stream 111010.

## Detailed Description

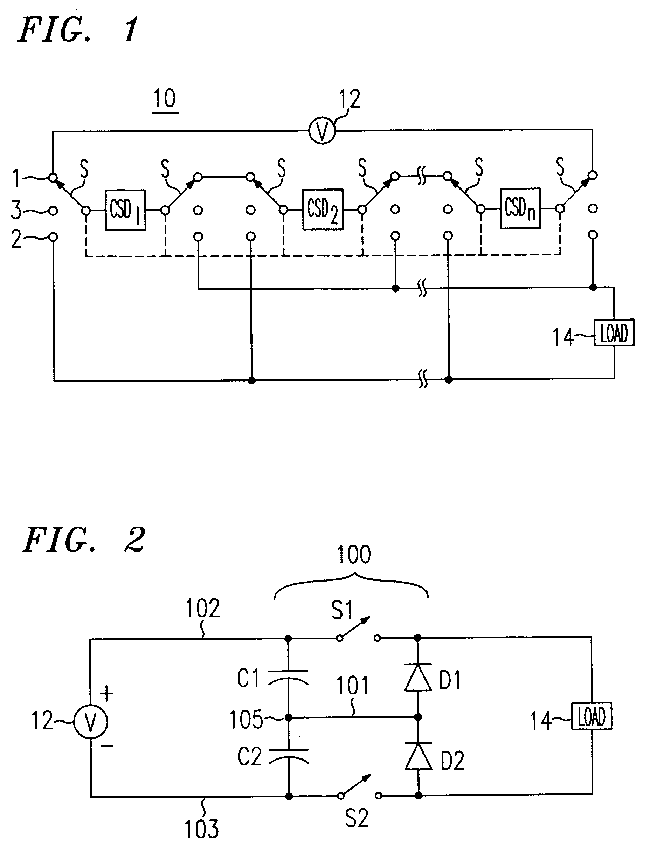

Turning now to the drawing, FIG 1 shows a current multiplication network 10 comprising a plurality N of charge storage devices CSDn (n = 1,2...N) and switches S arranged to have one network configuration during a charging interval and another network configuration during a discharging interval. As described in greater detail below, the network 10 enables an average current $NxI$ to be delivered to the load 14, even though the power supply 12 delivers only an average current I to the network 10. This feature allows designers to deliver more current to a load than is drawn from a supply or utilize a lower rated power supply for a given load requirement.

The term *charge storage device*, as noted earlier, includes, for example, open-circuited transmission lines (TLs), microstorage batteries, and simple capacitors, or combinations of such devices in a given network. The term *transmission line* includes typical two-conductor TLs, such as those formed as strip lines, as well as equivalent circuits of TLs, whether fabricated from discrete elements, integrated circuit elements, or both. In embodiments employing TLs, it will be assumed, for sake of clarity, that the TLs are substantially identical to one another and that the charging and discharging intervals are approximately equal to, but slightly less than, the round-trip delay time $2\tau$ of each TL. However, it will be appreciated by those skilled in the art that the TLs need not be identical to one another.

The term *switch* includes, for example, solid state devices such as bipolar transistors, FETs, diodes, photodiodes, photoconductors, phototransistors etc. As an aid to clarity, we ignore the effects of finite, non-zero, voltage drops across closed switch contacts.

System considerations, such as the baud rate of a digital signal, often determine which type of CSD is best suited to a particular application. For example, at baud rates of a few 100 M baud or less, TLs are too long for practical use in most physical designs. On the other hand, capacitors may be suitable at much lower baud rates (e.g., 1 M baud or less) depending on capacitance. At higher baud rates (e.g., in the giga baud range), however, both TLs and capacitors would be suitable. In contrast, at a relatively lower baud rate where TLs and capacitors may not be practical, microstorage batteries can be used because they provide a relatively constant voltage over time intervals of interest; i.e., as long as they are not fully discharged.

The two network configurations in FIG. 1 are controlled by the state of ganged switches S each of which has a first charging position 1, a second discharging position 2, and an optional idle position 3. During a charging interval, switches S are all in charging position 1, which connects all of the CSDs in series with the supply 12. The supply delivers a charge Q to each CSD and charges each to a voltage $V/N$. In contrast, during a discharging interval, all of the switches are in discharging position 2, which connects all of the CSDs in parallel with the load 14. Thus, a total charge of $QxN$ is delivered to the load. For a given time interval this charge corresponds to a current multiplication of $M = N$. A controller, well known in the art, for determining the state of the switches has been omitted for simplicity.

In embodiments of FIG. 1 in which the CSDs are TLs, care should be exercised to match impedances. More specifically, in order for the TLs to deliver substantially all of their current into the load, with minimum reflections, the impedance $Z_L$ of the load should be matched to that of the parallel group of TLs; i.e., $Z_L = Z_o/N$, where $Z_o$ is the characteristic impedance of each TL and N is the number of TLs in the parallel group.

The simplified network 10 of FIG. 1 has been described first to provide a basic understanding of how CSDs may be charged in series, and then discharged in parallel to effect current multiplication. Since charging and discharging take place in separate time intervals, this network design would be useful in digital systems where the coding scheme always returns to zero during each bit interval (i.e., RZ coding). In many other applications, however, it may not always be desirable, or necessary, that during each time interval, all CSDs are charged or all CSDs are discharged. It will often suffice, and indeed may be preferable, that only a first subset is charged while simultaneously a second subset is discharged, as discussed below, with reference to the networks shown in FIGs. 2, 3, and 5. Similar components in FIGs. 1, 2, 3, and 5 have been given identical reference numerals to facilitate comparison.

Thus, a network for achieving a current multiplication of $M = 2$ is shown in FIG. 2 where the CSDs are represented by capacitors C1 and C2. Network 100, connected in parallel with load 14, alternates between causing the supply 12 to charge C1 to a charge Q while simultaneously causing C2 to discharge by a charge Q into the load 14, and, conversely, charging C2 and discharging C1 in similar fashion.

Illustratively, network 100 comprises capacitors C1 and C2 connected between a common node 105 and opposite supply lines 102 and 103, as well as current steering devices (e.g., diodes D1 and D2) also connected between common node 105 and opposite sides of load 14. Relative to node 105 the diodes are oppositely poled. Network 100 also includes switches S1 and S2 which are connected to lines 102 and 103, respectively, between capacitors C1 and C2, respectively, and opposite sides of load 14.

In operation, the capacitors C1 and C2 are not discharged completely; that is, we intend to use only a portion of the total stored charge in each capacitor. The exact portion is not critical (e.g., 1-20% of the total stored charge would be suitable). Suppose S1 is closed and S2 is open. Then C1 is discharging and C2 charging as follows: charge Q flows from the positive terminal of supply 12, and additionally charge Q flows from the top plate of C1, so that 2Q flows through S1 and to the load 14. No charge is diverted into D1 because it is reverse biased. The charge continues to flow through the load 14, and through D2 which is forward biased. It cannot flow through S2 which is open. At this time the total charge added to C2 is also Q (the total charge through supply 12).

As the charge continues to flow as described above, the voltage across C2 (between node 105 and line 103) starts rising above V/2. The network should be in this configuration for a brief enough time that the voltage across C1 is adequate to support the needed charge flow out of C1.

During the next time interval that charge is to be supplied to load 14, the states of the switches are reversed; that is, S2 is closed and S1 is open. Then, C2 is discharging and C1 charging as follows: charge flows from the top plate of C2, through node 105, through D1, through load 14, through S2, and back to supply 12. The total charge through load 14 is the charge Q through the supply plus the charge Q removed from C2. The amount of charge through load 14 is controlled by the voltage drop across C2. While the network is in this configuration, the voltage at node 105 will fall below V/2.

Over long periods of operation, the average change in charge on C1 is zero and similarly no average charging or discharging is occurring for C2. Thus, for equal average times where the same charge is extracted from C1 as from C2, the charge delivered to the load 14 is supplied half by the supply 12 and half by the capacitor being discharged at that moment. Since average current is total charge flow divided by total time, the ratio of charge flow is equal to the ratio of average currents. Thus, the average supply current is half the average load current; or equivalently, the load current is twice the supply current (on average), which corresponds to a multiplication factor of M = 2.

We note also that monitoring the voltage across C1 and/or across C2 compared to V/2 can be used to decide in which direction the switches should be set for most effective current supplying to the load.

In addition, *headroom* should be considered in any practical design. That is, the potential difference across either capacitor (C1 or C2)(about V/2) should be large enough to overcome operating voltage drops across D1 or D2, the load, and S1 or S2. To operate at small V, it may be necessary to use FETs to form the switches S1 and S2 as well as the diodes D1 and D2.

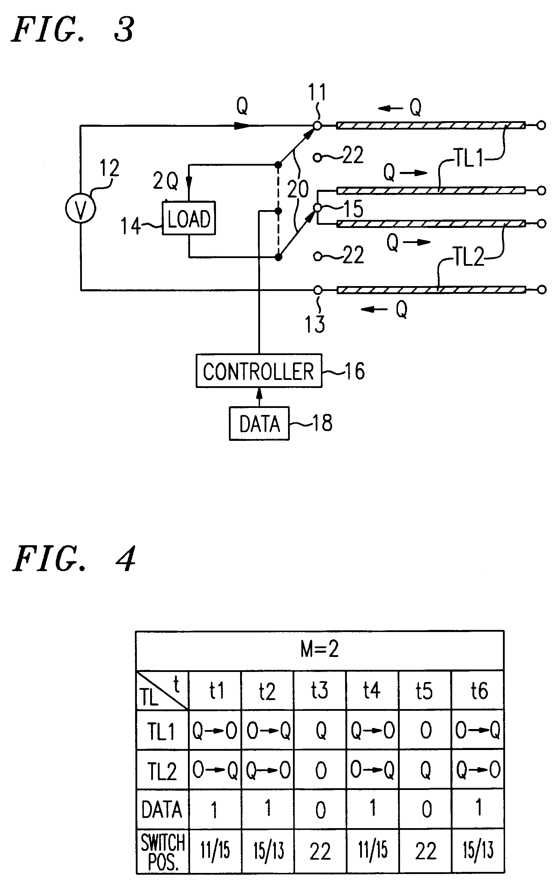

Another a network for achieving a current multiplication of M = 2 is shown in FIG. 3, but in this embodiment the CSDs are open-circuited transmission lines (TLs) rather than capacitors. More specifically, two open-circuited transmission lines TL1 and TL2 are connected in series across a power supply 12 which delivers a voltage V and a charge Q. A load 14 is switched by switching means 20 to one of three positions (the input of TL1, the input of TL2, or idle position 22) by controller 16 in response to a digital signal from source 18. In the idle position 22 the load 14 is disconnected from both TLs. Note, however, in an electronic switch, idle position 22 may be conceptual only; e.g., it may represent the state where no connection is made between the load and the TLs.

The two transmission lines are depicted in FIG. 3 as having four parallel conductor strips. However, it is well known in the art that they could be composed of three strips, with one of the three being in common; i.e., the lower strip of TL1 and the upper strip of TL2 could be in common.

As noted earlier, the impedance of the load is preferably matched to that of the TLs; that is, $Z_L = Z_o/2$. If perfect impedance matching were possible, the idle position 22 of switch 20 could be omitted. But, in practice, utilizing a switch with such an idle position is desirable in order to eliminate relaxation oscillations of current due to reflections between the load and the TLs.

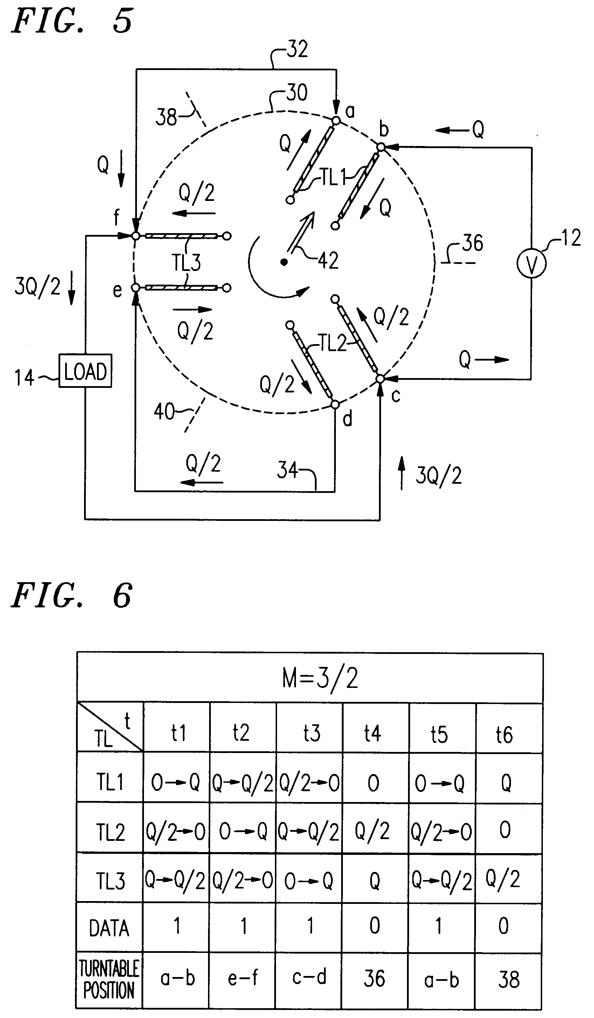

The operation of FIG. 3 in six successive time intervals t1 - t6 is described with reference to FIG. 4 which depicts how the charge Q changes in each TL in response to a digital signal defined by an illustrative binary bit stream 110101. As before, and as hereinafter in FIGs. 5-6, the duration of each time interval $t_i$ (i = 1,2...) is essentially equal to $2\tau$, the round-trip delay line of each TL. More specifically, the operation of the network of FIG. 3 starts by assuming that (1) node 13 is at a reference potential (e.g., ground), (2) the voltage at node 11 (relative to node 13) is the supply voltage V, and (3) the voltage $V_m$ at middle node 15 varies between 0 and V (relative to node 13). When TL1 is fully charged and TL2 is fully discharged, $V_m$ = 0. Conversely $V_m$ = V when the charge states of the TLs are reversed. For purposes of discussion, assume that initially TL1 has been fully charged with a charge Q, and TL2 has been fully discharged to zero. At the beginning of time interval t1, FIG. 4 shows that the digital signal is represented by a logic 1 state which we define as requiring charge flow through the load. To this end the controller connects the load 14 across TL1. Since TL1 is fully charged, it supplies a charge Q to the load. The charge Q from TL1 is summed with a charge Q from supply 12 to deliver a total charge 2Q to the load. Thus, during t1, TL1 is discharged; but, simultaneously, TL2 is being charged automatically from zero to Q in preparation for the occurrence of a subsequent logic 1 state. Thus, at t2 the digital signal is again represented by a logic 1 state, as shown in FIG. 4, which causes the controller to switch the load across TL2. Once again, the supply 12 supplies a charge Q to the load, but this time TL2 supplies the additional Q for a total of 2Q delivered to the load. Simultaneously, TL1 is being recharged from 0 to Q.

A different situation occurs at t3 when the digital signal is represented by a logic 0 state, as shown in FIG. 4. In this case, the logic 0 state is interpreted as meaning that essentially no charge should flow through the load, and so, illustratively, the controller 16 moves the switching means 20 to the idle position 22. In this position, no charge from either of the TLs or the supply is delivered to the load. In addition, since TL1 was charged during t2, $V_m$ = 0. During t3 it remains charged and TL2 remains discharged. In a similar fashion, the remaining illustrative logic states 101 in intervals t4 - t6, respectively, cause M = 2 multiplication in t4 and t6. But, in t5 no current is drawn from the supply 12 and no current is supplied to load 14.

A network for providing M = 3 current multiplication is not shown but, in principle, would be readily constructed by one of ordinary skill in the art. In brief, such a network of three open circuited TLs and a controller would be designed so that, during each time interval, two TLs are charged while simultaneously one TL is connected across the load and is discharged. During successive logic 1 states, different TLs are discharged in cyclic fashion. In theory, multiplication by any integer N can be achieved in this fashion by logical extension to N transmission lines which are discharged one at a time. Of course, larger multiplication factors imply more complex networks and more complex controllers.

Although the above discussion relates to networks capable of current multiplication by integral multipliers, the invention can also be designed to realize multiplication by multipliers M which are the ratio of two integers. An illustrative embodiment in which M = 3/2 is shown in FIG. 5. During each time interval in which current is to be delivered to the load, two TLs are connected in series with one another and are partially discharged by a charge Q/2, and simultaneously one TL is charged with a charge Q. For impedance matching purposes $Z_L$ = $2Z_o/3$. More specifically, the network of FIG. 5 comprises open circuited transmission lines TL1, TL2 and TL3 arranged, for purposes of exposition, radially on turntable 30 at angular positions which are 120° apart, e.g., at 60°, 180°, and 300°. The position of turntable 30 is indicated by arrow 42. The switch contacts a - f are fixed; i.e., they do not rotate with the turntable. In the position shown in FIG. 5, the supply 12 is connected between switch contacts b and c, whereas load 14 is connected between contacts f and c. Conductor 32 connects contacts a and f, and conductor 34 connects contacts e and d. TL1 is connected to contacts a - b, TL2 to c - d, and TL3 to e - f. The effect of this circuit arrangement is that TL2 and TL3 are connected in series with one another and across the load 14. The supply 12 and TL1 are connected in series with one another and also across the load 14. In operation, the supply 12 charges TL1 with a charge Q while simultaneously load 14 discharges TL2 and TL3, both by a charge Q/2 during particular time intervals. As demonstrated at contact f, the load receives a total charge 3Q/2, with Q being contributed over conductor 32 by TL1 and Q/2 being contributed by TL3. During a subsequent time interval, the turntable may rotate to either of two positions: (1) in response to a logic 1 state, the turntable would rotate counter clockwise by 120° so that TL2 would be connected in the charging position across contacts a - b, and TL1 and TL3 would be connected across contacts f - e and d - c, respectively; or, (2) in response to a logic 0 state, the turntable would rotate by an angle other than 120°, say 60° to the idle position shown by reference numbers 36, 38, 40 so that supply 12 is disconnected from the TLs. As before, if the load and the TLs are perfectly matched, the TLs need not be switched to an idle position because at the end of time interval $2\tau$ the flow of charge ceases.

Operation of the network of FIG. 5 in response to a digital signal represented by an illustrative binary bit stream 111010, shown in FIG. 6, will now be described. A controller for rotating the turntable in response to the digital signal has been omitted for simplicity. Initially, it will be assumed that TL1 has previously been fully discharged to zero, TL2 has been discharged from Q to Q/2, and TL3 had been charged from zero to Q. When a logic 1 state occurs during the first time interval t1, as shown in FIG. 6, TL1 is charged to Q, TL2 is discharged from Q/2 to zero, TL3 is discharged from Q to Q/2. Charge Q from TL1 and Q/2 from TL3 are summed at contact f so that 3Q/2 is delivered to load 14, even though supply 12 supplies only Q.

Therefore, over the $2\tau$ time interval the current multiplication is 3/2. Now, when another logic 1 state occurs at t2, the turntable rotates counterclockwise by 120° so that TL2 is charged to Q, TL1 is discharged from Q to Q/2, and TL3 is discharged from Q/2 to zero. Again, 3Q/2 is delivered to the load.

This sequence of events is repeated for the logic 1 state which occurs during interval t3. However, during interval t4, a logic 0 state occurs which means that essentially no charge should flow through the load. In this case, the turntable rotates to the idle position 36 (alternatively supply 12 is turned off) where TL1 remains fully discharged, TL2 stays charged at Q/2 and TL3 stays charged at Q. Next, when a logic 1 state occurs at t5, the turntable completes the counter-clockwise rotation so that the TLs are aligned with contact pairs a - b, c - d, and e - f, and the operation follows the description above for intervals t5 and t6.

As discussed earlier, although the use of idle position 36, 38, 40 is optional, their inclusion may be preferred for most practical applications. In addition, the turntable itself is intended to be conceptual; that is, the turntable is a mechanical equivalent of an electronic switching circuit which could be readily designed by one of ordinary skill in the art to enable the supply 12 and load 14 to be connected to and/or disconnected from the proper TLs during each time interval. In addition, the invention has been described in terms of a network having N open-circuited TLs divided into two subsets: in one subset, K TLs are connected in series with one another and are discharged together; and in the other subset, (N-K) TLs are also connected in series with one another and are charged together during each time interval in which current is to be delivered to a load. In this case the multiplication factor is N/K, and the load impedance $Z_L$ is preferably given by the following equation (1) for impedance matching purposes:

$$Z_L = Z_o \left[ \frac{K(N-K)}{N} \right] \quad , \qquad (1)$$

where $Z_o$ is the characteristic impedance of each TL. However, it is not essential that, during each time interval, every TL must be either charged or discharged. Those skilled in the art will recognize that, instead, one or more TLs may be idle.

In addition, the invention has been described in terms of designs in which the load is impedance matched to the discharging TLs. However, the invention also contemplates the use of mismatched designs. For example, if $Z_L$ is much less than the matched impedance value, a resonant condition can be established in which current oscillates between the load and the TLs in such a fashion that voltages much greater than the supply voltage are developed across the TLs. This higher voltage, in turn, means that higher currents can be delivered to the load. Under these circumstances, the discharging of a TL need not necessarily result in zero charge in that TL beyond the time interval; rather, overshoot is likely to occur such that the TL, initially charged to one polarity, is first discharged and then partially recharged to the opposite polarity.

Finally, the illustrative systems described so far have assumed binary (on-off) logic in a system in which the time intervals were of equal length. However, the invention is applicable to other kinds of logic (e.g., tri-state) and to intervals of unequal length (e.g., pulse width modulation schemes). Moreover, it will be appreciated that the multiplication factor M need not be the same in every time interval; i.e., it may vary from one interval to another.

**Claims**

1. A network (e.g., FIG. 2; FIG. 3) for delivering a current MxI (M > 1) to a load (14) from a supply (12) which delivers a current I, comprising:

   a plurality of charge storage devices (C1, C2; TL1, TL2);
   CHARACTERIZED BY
   a switching circuit (S1, S2; 20) for connecting a first subset (e.g., C1; TL1) of said devices to said supply so as to charge said first subset and for essentially simultaneously connecting a second subset (e.g., C2; TL2) of said devices to said load so as to discharge said second subset into said load.

2. The network of claim 1 for delivering said current to said load during selected time intervals of a digital signal, further including:

   a controller (16) which controls said switching circuit in response to said digital signal so that during one of said selected time intervals said first subset is charged and said second subset is discharged, but, during another one of said selected time intervals, a different first subset is charged and a different second subset is discharged.

3. The network of claim 1 wherein the devices in at least one of said subsets are connected in series with one another.

4. The network of claim 3 wherein the devices in both of said subsets are connected in series with one another.

5. The network of claims 1, 2, 3 or 4 wherein said devices comprise open-circuited transmission lines.

6. The network of claim 5 for delivering said current to said load during selected time intervals of a digital signal and wherein each of said transmission lines has a round-trip delay time of $2\tau$, the duration of said selected time intervals being approximately equal to $2\tau$.

7. A network (e.g., 10, FIG. 1) for delivering a multiplied current to a load (14) from a supply (12) which delivers a lower current to said network, comprising
   a plurality of charge storage devices (CSD: CSD2, CSD3), and
   means (S) for charging said devices to a predetermined charge level,
CHARACTERIZED BY
   a controller for arranging said devices to have a first circuit configuration during a first time interval in which they are charged and for arranging said devices to have a second circuit configuration during a second time interval in which they are discharged into said load.

8. The network of claim 7 wherein, in said first configuration, said devices are connected in series with said supply and, in said second configuration, said devices are connected in parallel with said load.

9. A network (FIG. 2; FIG. 3) for deliverying a current 2I to a load (14) from a supply (12) which delivers a current I, comprising
   first and second charge storage devices (C1, C2; TL1, TL2);
CHARACTERIZED BY
   a switching circuit (S1, S2; 20) which configures said network so that, during a first time interval, (1) said first device is discharged and the total charge delivered to said load is the sum of the charge from said first device and the charge from said supply, and (2) said second device is charged by said supply, and further so that, during a second time interval, (3) said second device is discharged and the total charge delivered to said load is the sum of the charge from said second device and the charge from said supply, and (4) said first device is charged by said supply.

10. The network of claim 1, 2, 3, 4, or 9 wherein said devices comprise capacitors.

11. The network of claim 9 wherein said devices comprise open-circuited transmission lines each having a round trip delay time $2\tau$ which is approximately equal to the duration of each of said time intervals.

FIG. 1

FIG. 2

# FIG. 3

# FIG. 4

| M=2 | | | | | | |
|---|---|---|---|---|---|---|
| TL \ t | t1 | t2 | t3 | t4 | t5 | t6 |
| TL1 | Q→0 | 0→Q | Q | Q→0 | 0 | 0→Q |
| TL2 | 0→Q | Q→0 | 0 | 0→Q | Q | Q→0 |
| DATA | 1 | 1 | 0 | 1 | 0 | 1 |
| SWITCH POS. | 11/15 | 15/13 | 22 | 11/15 | 22 | 15/13 |

## FIG. 5

## FIG. 6

| | M=3/2 | | | | | |
|---|---|---|---|---|---|---|
| TL \ t | t1 | t2 | t3 | t4 | t5 | t6 |
| TL1 | 0→Q | Q→Q/2 | Q/2→0 | 0 | 0→Q | Q |
| TL2 | Q/2→0 | 0→Q | Q→Q/2 | Q/2 | Q/2→0 | 0 |
| TL3 | Q→Q/2 | Q/2→0 | 0→Q | Q | Q→Q/2 | Q/2 |
| DATA | 1 | 1 | 1 | 0 | 1 | 0 |
| TURNTABLE POSITION | a−b | e−f | c−d | 36 | a−b | 38 |